# EUROPEAN PATENT SPECIFICATION

(11) **EP 0 869 102 B1**
(45) Date of publication and mention of the grant of the patent: **22.05.2002**
(21) Application number: 96933633.8
(22) Date of filing: 14.10.1996
(51) Int. Cl.: C01B 33/02, C01B 33/037, C30B 28/06, C30B 29/06, H01L 31/04

(54) **PROCESS AND APPARATUS FOR PREPARING POLYCRYSTALLINE SILICON AND PROCESS FOR PREPARING SILICON SUBSTRATE FOR SOLAR CELL**
VERFAHREN UND VORRICHTUNG ZUR HERSTELLUNG VON POLYKRISTALLINEM SILIZIUM UND VERFAHREN ZUR HERSTELLUNG EINES SILIZIUMSUBSTRATS FÜR EINE SOLARZELLE
PROCEDE ET APPAREIL DE PREPARATION DE SILICIUM POLYCRISTALLIN ET PROCEDE DE PREPARATION D'UN SUBSTRAT EN SILICIUM POUR CELLULE SOLAIRE

(43) Date of publication of application: 07.10.1998
(73) Proprietor: Kawasaki Steel Corporation, Chuo-ku, Kobe-shi, Hyogo 651 (JP)
(72) Inventor: ARATANI, Fukuo, Technical Research Laboratories, Chuo-ku, Chiba-shi, Chiba-ken 260 (JP); KATO, Yoshiei, Technical Research Laboratories, Chuo--ku, Chiba-shi, Chiba-ken 260 (JP); SAKAGUCHI, Yasuhiko, Technical Research Lab., Chuo-ku, Chiba-shi, Chiba-ken 260 (JP); YUGE, Noriyoshi, Technical Research Lab., Chuo-ku, Chiba-shi, chiba-ken 260 (JP); BABA, Hiroyuki, Technical Research Lab., Chuo-ku, Chiba-shi, Chiba-ken 260 (JP); NAKAMURA, Naomichi, Technical Research Lab., Chuo-ku,Chiba-shi, Chiba-ken 260 (JP); HANAZAWA, Kazuhiro, Technical Research Lab., Chuo-ku, Chiba.shi, Chiba-ken 260 (JP)
(74) Representative: Grünecker, Kinkeldey, Stockmair & Schwanhäusser Anwaltssozietät
(86) International application number: JP9602965
(87) International publication number: WO9816466

(56) References cited:
- JP-A- 4 130 009
- JP-A- 4 240 192
- JP-A- 58 172 219
- JP-A- 61 232 295
- JP-A- 62 260 710
- JP-B- 59 013 444

## Description

### BACKGROUND OF THE INVENTION

### 1. Field of the Invention

This invention relates to a process and apparatus for manufacturing polycrystalline silicon and a process for manufacturing a silicon wafer for a solar cell. In particular, this invention pertains to a technique which employs metallic silicon or silicon oxide as a starting material and permits the continuous flow production from polycrystalline silicon to an end product, that is, a polycrystalline silicon wafer for a solar cell.

### 2. Description of the Related Art

Studies on solar cells have been made for many years. Recently, those having a photoelectric transfer efficiency of even about 13 to 15% under sun light on the ground have appeared and they are now being industrialized for various applications. In our country, however, solar cells are not so popular as an energy source for domestic electric power, automobiles, ships or machine tools, because a technique to mass-produce a silicon wafer at a low cost, which is necessary for the manufacture of solar cells, has not yet been established.

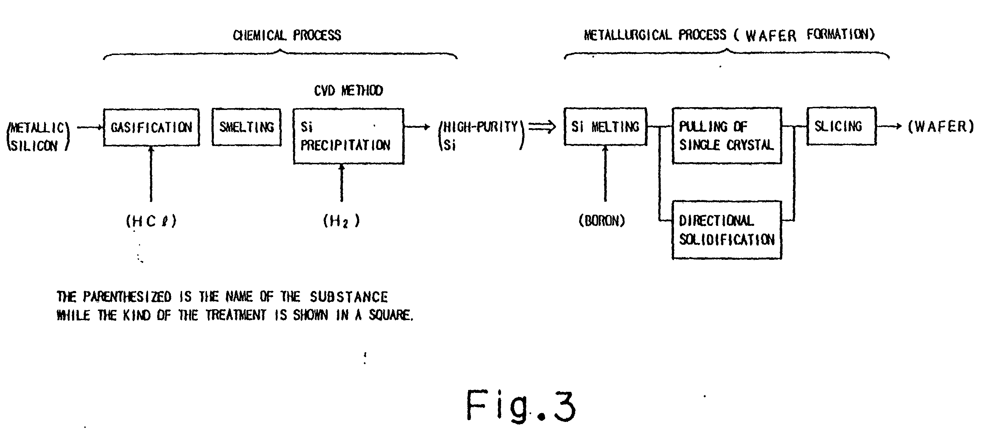

At present, for the manufacture of a silicon wafer for a solar cell, a high-purity silicon, which is in the mass form and conforms to the specification of a semiconductor, is once manufactured through a chemical process by using as a starting material a low purity metallic silicon (99.5 wt.% Si). Then, high-purity silicon in the mass form is re-melted and is adjusted to have a chemical composition suited to a solar cell by a metallurgical process. The resulting molten silicon is formed into an ingot by the pulling method or directional solidification method, followed by slicing into thin plates. Described specifically, as shown in FIG.3, metallic silicon is first reacted with hydrochloric acid and formed into a trichlorosilane gas. After the gas so obtained is fractionated to remove the impurity elements, the residue is reacted with a hydrogen gas, whereby high-purity silicon is precipitated from the gas by the so-called CVD (Chemical Vapor Deposition) method. The high-purity silicon therefore becomes only an aggregate of silicon grains owing to the weak bonding power between crystal grains. The boron contained in the high-purity silicon forming the aggregate is reduced even in the order of 0.001 ppm and does not reach the concentration necessary for satisfying the specific resistivity of 0.5 to 1.5 ohm·cm which is the specification for P-type semiconductor wafer. In order to use the above high-purity silicon for a solar cell, it is indispensable to adjust the specific resistivity and to control the crystallinity of single crystals or crystal grains so as have a particle size not smaller than several mm and have a grain boundary so as not to exert adverse effects on the photoelectric transfer efficiency. The above silicon cannot be formed into a wafer without further treatment. As shown in the right hand of FIG. 3, it becomes necessary to form a wafer after re-melting the high-purity silicon mass, adjusting the components of the melt (by the addition of boron) and forming into an ingot (pulling method for single crystals, while directional solidification for polycrystals).

The above-described manufacturing method is however accompanied with the drawbacks that it requires much labor to re-adjust (mainly, by the addition of boron) the components of a silicon ingot, which has a purity intentionally heightened to be suitable for semiconductor, to be suitable for solar cells or to purify the ingot; its yield is inferior; it additionally requires equipment and energy for re-melting; and therefore it costs high. As described above, the solar cells available now are therefore expensive, which prevents them from being popularly used. The purity heightening of metallic silicon by a chemical process is also accompanied with the generation of a large amount of pollutants such as silane and chloride, which prevents mass-production. According to the technique recently disclosed, the manufacturing process tends to be studied, divided into steps such as purity increase of metallic silicon or solidification technique, which is presumed to be influences by the above-described manufacturing method.

For example, Japanese Published Unexamined Patent Application No. HEI 5-139713 discloses a process in which silicon having a low boron content is obtained by maintaining molten silicon in a container composed of silica or composed mainly of silica, and injecting a plasma gas jet flow of an inert gas to the surface of the molten silicon, while blowing an inert gas upwardly from the bottom of the container. Japanese Published Unexamined Patent Application No. HEI 7-17704 discloses a process permitting the efficient removal of boron by forming 1.5 to 15 kg of SiO₂ per kg silicon in advance on the surface of metallic silicon powders upon melting metallic silicon through an electron beam. Concerning solidification technique, Japanese Published Unexamined Patent Application No. SHO 61-141612 proposes a technique to prevent, upon casting molten silicon into a mold, precipitation of inclusion in a silicon ingot by turning the mold. In addition, the present applicants themselves are now proposing a method for purifying molten metallic silicon by directional solidification in Japanese Patent Application HEI 7-29500 (filed on February 17, 1995).

It is impossible to say that there does not exist a technique to manufacture solar cell silicon directly from metallic silicon. For example, Japanese Published Unexamined Patent Application No. SHO 62-252393 discloses a process in which a starting material silicon, which is once used as a semiconductor but disposed as an electron industry waste, is subjected to zone melting by plasma jet generated by a mixed gas of argon, hydrogen and oxygen. This process aims principally at the use of an industrial waste so that it does not become a mainly-employed technique suited for mass production of a silicon wafer. In addition, although silicon is used as a raw material, its purity has been once increased so that the process is only a variation of the above-described cumbersome manufacturing process. Japanese Published Unexamined Patent Application No. SHO 63-218506 discloses a process for manufacturing, by plasma melting, silicon in the mass form for solar cells or electronics from metallic silicon in the form of powders, granules or polished dusts. This method is based on the principle of the zone melting method using the same plasma as that disclosed in the above Japanese Published Unexamined Patent Application No. SHO 62-252393 and is accompanied with the drawback that mass production cannot be carried out in spite of large electricity consumption. According to Examples of the above official gazette, only a silicon rod of 50 g or so is obtained on a laboratory scale and it does not include a description of increasing the size of the silicon wafer for a solar cell to a practical size.

### SUMMARY OF THE INVENTION

With the forgoing in view, an object of the present invention is to provide a process and apparatus for mass-producing, at a low cost in continuous flow production, polycrystalline silicon by using metallic-grade silicon or silicon oxide as a starting raw material, and a wafer manufactured using it.

With a view to attaining the above object, the inventors of the present invention have carried out an extensive investigation, paying attention to obtaining the maximum economic effects without using a chemical process but only a metallurgical process, leading to the completion of the present invention.

In a first aspect of the present invention, there is thus provided a process for manufacturing polycrystalline silicon from metallic-grade silicon, which comprises the following steps:
A: melting metallic-grade silicon under vacuum to remove the phosphorus contained therein by evaporation, and then carrying out directional solidification of the residue for the removal of the impurity elements from the molten silicon (which may hereinafter be called "melt"), thereby obtaining a first ingot;
B: removing the impurity concentrated portion of the first ingot by cutting;
C: re-melting the remaining portion, removing boron and carbon from the melt by oxidizing under an oxidizing atmosphere, and in succession, blowing an argon gas or a mixed gas of argon and hydrogen into the melt for deoxidization.
D: casting the deoxidized melt in a mold, followed by directional solidification to obtain a second ingot; and
E: removing the impurity concentrated portion of the second ingot by cutting.

In a further aspect of the present invention, there is also provided a process for the preparation of polycrystalline silicon, wherein in the above-described process, said metallic-grade silicon is obtained by reductive smelting of silicon oxide.

In a still further aspect of the present invention, there is also provided a process for the preparation of polycrystalline silicon, which comprises forming the above-described oxidizing atmosphere from an H₂O, CO₂ or O₂ gas in an amount small enough so that the whole interface between the melt and the gas will not be covered with silicon oxide, removing silicon oxide formed on the surface of the melt by locally heating by plasma arc, or blowing an H₂O, CO₂ or O₂ gas into the melt instead of placing the melt under the above-described oxidizing atmosphere.

In a still further aspect of the present invention, there is also provided a process for the preparation of polycrystalline silicon, which comprises using SiO₂ or Si₃N₄ as a mold releasing agent, setting a solidification interface moving rate at 5 mm/min or less, said solidification being carried out for the removal of impurities, setting a solidification interface moving rate at 2 mm/min or less for directional solidification, or cutting the ingot at a height at least 70% above the bottom of the ingot.

In a still further aspect of the present invention, there is also provided a process for the preparation of polycrystalline silicon which comprises setting a phosphorus concentration of the melt at 0.3 ppm or less and a boron concentration at 0.6 ppm or less or a carbon concentration at 10 ppm or less.

The present invention also relates to an apparatus for manufacturing polycrystalline silicon. In a still further aspect of the present invention, there is also provided an apparatus for manufacturing polycrystalline silicon, which comprises heating means for melting or heating metallic-grade silicon, a retaining container for retaining molten metallic silicon, a first directional solidification mold in which the melt is cast from the retaining container, a vacuum chamber for removing phosphorus by evaporation, said chamber surrounding the retaining container and the first mold, re-melting means for re-melting or heating a portion of the ingot from the first mold, a smelting container for retaining the re-melt, a nozzle for blowing or spraying an oxidizing gas, hydrogen gas or a mixed gas of hydrogen and argon to the re-melt in the smelting container and a second directional solidification mold for forming the deoxidized re-melt into a cast ingot.

In a still further aspect of the present invention, there is also provided an apparatus for manufacturing polycrystalline silicon, wherein the pressure in the above-described vacuum chamber is set at 1.33Pa (10⁻³ torr) or lower, the retaining container is a water-cooling jacket made of copper or a graphite crucible; and the smelting container is a crucible made of SiO₂, or an SiO₂ lined crucible.

In a still further aspect of the present invention, there is also provided an apparatus for manufacturing polycrystalline, wherein the above-described heating means is an electron gun; or the above-described re-melting means is a plasma torch or a DC arc source.

In a still further aspect of the present invention, there is also provided an apparatus for the preparation of polycrystalline silicon, wherein the above-described first and second molds have side walls formed of a heat insulating material and have a bottom formed of a water cooling jacket; and a heating source for heating the cast melt is disposed above the molds; or a W/H ratio, that is, the ratio of the diameter W to the height H of said mold is set at greater than 0.5.

In a still further and essential aspect of the present invention, there is thus provided a process for the manufacture of a silicon wafer for a solar cell, which comprises slicing an ingot of polycrystalline silicon, which has been obtained by any one of the above-described processes, to a thickness of 100 to 450 µm.

According to the present invention, polycrystalline silicon or a silicon wafer for a solar cell is manufactured by any one of the above-described methods or apparatuses so that the component adjustment of high-purity silicon, which is indispensable in the conventional method, is not required. The present invention also makes it possible to reduce the unnecessary consumption of energy. Since not a chemical process which is characterized by the generation of a large amount of pollutants but only a metallurgical process is adopted, the present invention makes it possible to enlarge the production equipment. As a result, a silicon wafer for a solar cell having excellent photoelectric transfer efficiency can be provided at a cost by far lower than the conventional one. Furthermore, polycrystalline silicon obtained by the enforcement of the present invention can be used effectively not only for the manufacture of a wafer but also for the use as a raw material for iron manufacture or the like.

As described above, the present invention makes it possible to avoid the consumption of unnecessary energy and enlarge the manufacturing equipment, thereby mass-producing polycrystalline silicon or polysilicon wafer for a solar cell having relatively good purity. As a result, a polycrystalline silicon wafer for a solar cell which has a photoelectric transfer efficiency on the ground on the same level with that obtained in the conventional method can be obtained at a markedly low cost, from which the wide diffusion of solar cells are much expected. Polycrystalline silicon can be used effectively as a raw material for iron manufacture as well as that for a wafer.

According to the present invention, high-purity polycrystalline silicon and a silicon wafer for a solar cell can be manufactured through a continuous flow production based on only a metallurgical process. Accordingly, the equipment can be enlarged freely and unnecessary energy can be omitted. The present invention is therefore very useful for the manufacture of a silicon wafer for a solar cell.

### BRIEF DESCRIPTION OF THE DRAWINGS

FIG. 1 is a flow chart illustrating one embodiment of a manufacturing process of polycrystalline silicon and a silicon wafer for a solar cell according to the present invention;
FIG. 2 is a schematic view illustrating an apparatus embodying the manufacturing process of polycrystalline silicon and a silicon wafer for a solar cell according to the present invention;
FIG. 3 is a flow chart illustrating the conventional process for manufacturing a silicon wafer for a solar cell.

### DETAILED DESCRIPTION OF THE PREFERRED EMBODIMENTS

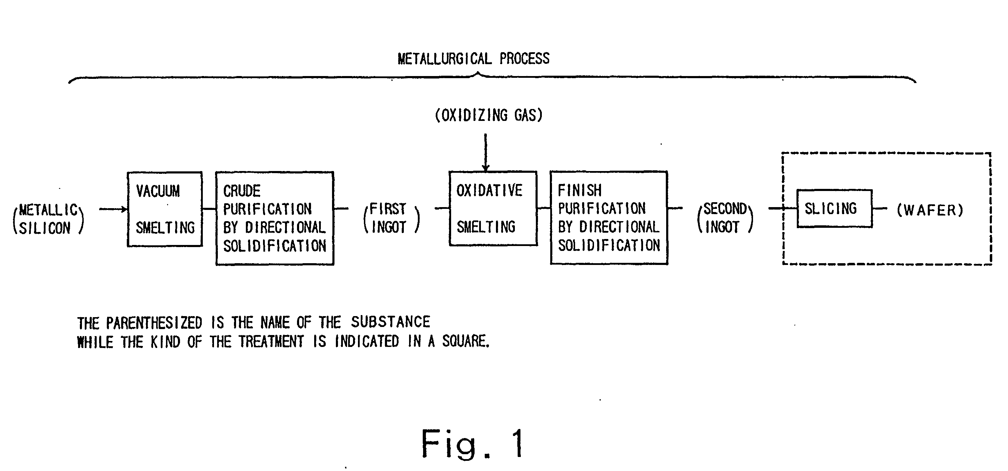

In FIG. 1, one embodiment of the manufacturing process of polycrystalline silicon and a silicon wafer for a solar cell according to the present invention is shown together in one flow chart (manufacture of the wafer is shown, enclosed with a dotted line).

First, metallic silicon having a relatively low purity (99.5 wt.% Si) is charged in a retaining container made of graphite or a water-cooling retaining container made of copper and then melted under vacuum. At this time, heating may be conducted making use of the methods known to date such as gas heating or electric heating, with heating by an electron gun being most preferred. Here, the metallic silicon so melted is maintained for a predetermined time (for example, 30 to 60 minutes) in the above retaining container at a temperature not lower than 1450° C but not higher than 1900° C, whereby phosphorus and aluminum, among impurity elements contained in the melt, are removed by evaporation (vacuum smelting). It is preferred that the phosphorus concentration in the melt is 0.3 ppm or less. Then, in order to remove the impurity elements such as Fe, Al, Ti and Ca to be 100 ppm or less, the melt is cast into a first cast and is cooled upwardly from the bottom so that the moving rate of solidification interface will be 5 mm/min. As a result, an ingot in which the melt having concentrated impurity elements has been solidified last is obtained.

In succession, the upper 30% portion of the ingot having the concentrated impurity elements therein is removed by cutting. The remaining portion of the ingot is charged in a melt furnace equipped with, for example, a plasma arc, whereby the ingot is re-melted. Also in this case, the heating means is not limited to the plasma arc. The melt is heated to a temperature not lower than 1450 ° C and at the same time is reacted with an oxidizing gas atmosphere, whereby boron and carbon are removed from the melt as oxides (oxidative smelting). After oxidative smelting, an argon gas or a mixed gas of argon and hydrogen is blown into the melt for a predetermined time. As a result, oxygen in the melt is deoxidized to the level not higher than 10 ppm. Incidentally, the above-described oxidative smelting may be carried out either in a vacuum chamber or in the air. The deoxidized melt is then cast into a second mold coated with a mold releasing agent, followed by directional solidification, whereby a final ingot is obtained. Impurity elements exist in the concentrated form in the upper portion of the ingot so that the portion (generally, 20% or so) is removed by cutting and the remaining portion is provided as a product of polycrystalline silicon.

Polycrystalline silicon is prepared as described above. It is only necessary to slice the above-described remaining portion by a multi-wire saw into thin plates of 100 to 450 µm thickness.

Metallic-grade silicon, which is a starting material, is generally available by reductive smelting of silicon oxide so that the use of silicon oxide as a starting material is also added to the present invention. Any known methods can be employed to smelt silicon oxide into that having a purity on the same level with that of the metallic-grade silicon used in the first step of the present invention. For example, silicon oxide is melted and reduced by using a carboneous material as a reducing agent. In the present invention, considered is a method of removing the components, which are not necessary for polycrystalline silicon or a silicon wafer for a solar cell, in advance upon obtaining metallic silicon from silicon oxide. As a result, this process makes it possible to omit some of the apparatuses and brings about effects for reducing energy consumption, whereby polycrystalline silicon and a silicon wafer for a solar cell on the same level with those obtained by the above-described process of the present invention are available at a lower cost. In particular, if boron and carbon removal is conducted by those who prepare metallic silicon, operations subsequent to it can be carried out more easily by the manufacturer of polycrystalline silicon or wafer.

Incidentally, the reason for setting the moving rate of the solidification interface at 5 mm/min or lower in the case of the first mold and at 2 mm/min in the case of the second mold is because moving rates higher than the above disturb sufficient concentration of impurity metal elements in the upper part of the ingot. The reason for cutting the ingot at a height not lower than 70% from the bottom of the ingot is because the target composition as polycrystalline silicon can be attained at the remaining lower portion. In the present invention, the degree of vacuum in the vacuum chamber is set at 10-3 torr or higher because it is suited for phosphorus removal by evaporation judging from the vapor pressure of phosphorus in metallic silicon.

In the present invention, the phosphorus concentration of the melt is set at 0.3 ppm or lower in order to secure stable operation of solar cells, while the boron concentration of the melt is set at 0.6 ppm or lower in order to obtain polycrystalline silicon suited for a P-type semiconductor wafer. The carbon concentration set at 10 ppm or lower makes it possible to suppress the precipitation of SiC in silicon crystals, thereby preventing the lowering in the photoelectric transfer efficiency.

Furthermore, in the present invention, a copper-made water-cooling jacket or a graphite crucible is employed as the above-described retaining container upon melting of metallic silicon and an SiO₂ crucible or SiO₂ stamped or lined crucible is used as the above-described smelting container, because silicon tends to react with other substances and when a crucible made of another substance is used, component elements of the substance is mixed in silicon. Incidentally, when boron is removed upon preparation of metallic silicon, inexpensive Al₂O₃, MgO, graphite or the like can be employed for the lining of the refractory, because if impurities are mixed in, they can be removed at the subsequent step. The mold releasing agent of the mold used for solidification is specified to SiO₂ or Si₃N₄ because of the same reason. Since the molten silicon expands by 10% in volume when solidified, the mold releasing agent is necessary for preventing the stress from remaining on the ingot.

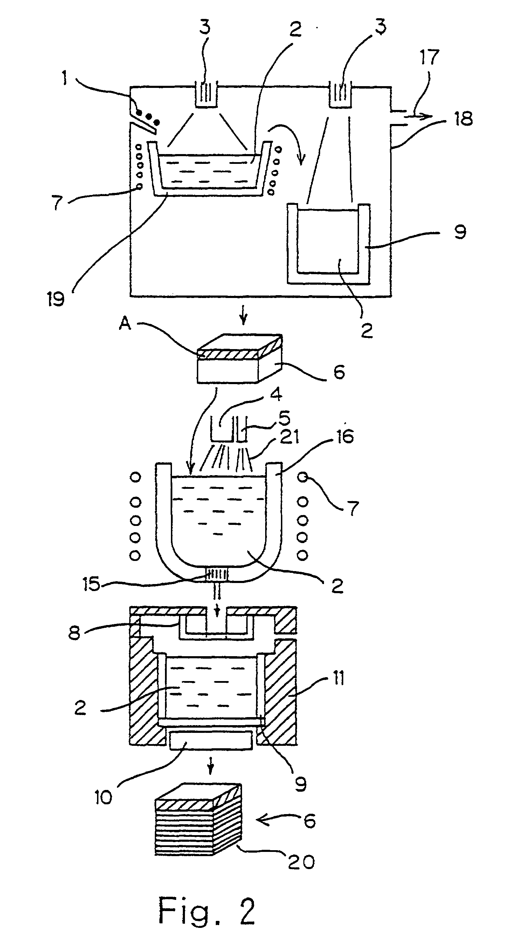

In addition, an apparatus according to the present invention is constructed so that as shown in FIG. 2, the melt 2 of metallic-grade silicon 1 flows to the subsequent stage almost continuously except at the time of solidification. This structure makes it possible to carry out preparation smoothly and to shorten the operation time, leading to the reduction in the manufacturing cost. Besides, since the apparatuses used in the present invention are operated based on only the metallurgical process, they can be enlarged considerably and are free from generation of pollutants. Cost reduction by mass production can also be expected.

The oxidizing atmosphere for the removal of boron and carbon from the melt 2 is not required to have high acidifying power. Preferred as the oxidizing gas is H₂O or CO₂. When acidifying power is high, an SiO₂ film is formed on the surface of the melt, which hinders the removal of boron and CO₂. In such a case, injection of arc from a plasma torch 4 or DC arc source is necessary for the removal of such a film. The above-described oxidizing gas may be blown directly into the melt. The material of a nozzle 5 from which the oxidizing gas is blown is limited to graphite or SiO₂, because other materials contaminate the melt 2. Incidentally, as a cutting machine (not illustrated) for cutting the ingot 6 released from the second mold 9 into thin plates, a known multi-wire saw or multi-blade saw can be used without problems. The reason why the thickness of the thin plate is set at 100 to 450 µm is because the plate is too weak at the thickness less than 100 µm, while it has lowered photoelectric transfer efficiency at the thickness exceeding 450 µm.

In the apparatus according to the present invention, a particular consideration is taken for the structure of the mold 9 in which solidification is carried out. Described specifically, as shown in FIG. 2, the mold is shaped into a so-called washball having a diameter W : height H ratio of 0.5 or greater. In addition, it is constructed to have a heat insulating material 11 as a side wall, a water-cooled jacket 10 as a bottom and a heating source 8 disposed in the upper part of the mold so that the moving rate of the solidification interface can be regulated.

In the present invention, it is also possible to carry out the solidification operations (solidification - re-melting) in the first mold and second mold in repetition. Alternatively, after a plurality of molds are provided and the above-described retaining container or smelting container is enlarged, the melt may be poured from the enlarged container in portions to the plural molds.

### (Example 1)

As shown in FIG. 2, an electron gun 3 of 300 KW in output was installed on the upper part of a vacuum chamber 18. Metallic-grade silicon 1 was fed to a retaining container 19 (which is also called a melting furnace) made of graphite at 10 kg/hour and was melted. At this time, the degree of vacuum in the vacuum chamber 18 was 10⁻⁵ torr. From the melt 2, a portion of phosphorus and aluminum elements were evaporated and removed. The remaining melt 2 was then cast into a water-cooling type copper-made mold 9. While the surface of the melt was exposed to electron beam 3 to maintain the molten state, the melt was solidified from the bottom at a solidification interface moving rate of 1 mm/min, whereby 50 kg of an ingot 6 were obtained. The upper 20% portion of the ingot 6 (the portion A) was removed by cutting to obtain an ingot having a chemical composition as shown in Table 1.

**Table 1**

| ( Unit:ppm ) | | | | | | | | |
|---|---|---|---|---|---|---|---|---|
| | B | P | Fe | Al | Ti | La | C | O |
| Metallic-grade silicon | 7 | 23 | 980 | 860 | 180 | 950 | ∼ 5000 | - |
| Ingot after crude purification | 7 | <0.1 | 10 | 8.5 | 2 | 10 | 35 | - |
| Wafer | 0.1 | <0.1 | <0.1 | <0.1 | <0.1 | <0.1 | 3.5 | 5.7 |

The remaining portion of the ingot 6 was then melted in a silica crucible (smelting container) 16 above which a plasma torch 4 of 100 KW in output was disposed. The melt was kept at a temperature of 1600 ° C and a mixed gas 21 of argon and water vapor, said gas containing 15 vol.% of water vapor, was sprayed to the surface of the melt. At this time, a sample was taken from the melt 2 and its specific resistivity was measured. About two hours later, the specific resistivity became 1 ohm· cm so that the mixed gas 21 was changed to an argon gas and deoxidization was effected for 30 minutes. The melt was then poured into a second mold which was made of graphite and coated with Si₃N₄ as a mold release agent and was solidified by cooling upwardly from the bottom under an argon gas atmosphere, whereby an ingot was obtained. At this time, a graphite heater 8 was disposed in the upper part of the mold 9 by which the surface of the melt was heated. As a result, the moving rate of the solidification interface was 0.7 mm/min.

After the completion of the solidification, the upper 30% of the ingot 6 so obtained was removed by cutting and the remaining portion of the ingot was provided as a product of polycrystalline silicon. The product so obtained was sliced into thin plates having a thickness of 350 µm, by a multi-wire saw, whereby 300 silicon wafers for solar cells, each wafer having a size of 15 cm x 15 cm, were manufactured. These wafers each had a specific resistivity of 1.2 ohm·cm, had a minority carrier whose life time was 12 µsec and, had a photoelectric transfer efficiency of 13.8%. Its chemical composition is as shown in Table 1.

### (Example 2)

In a similar manner to Example 1, an ingot 6 was obtained from the first mold. The upper 70% portion of the ingot was melted in a silica crucible (smelting container) 16 above which a plasma torch 4 of 100 KW in output was disposed. Into the melt 2 maintained at 1600 ° C, a mixed gas 21 of argon and water vapor, said gas containing 15 vol.% of water vapor, was blown at a rate of 10 liter/min through a porous plug 15 disposed at the bottom of the crucible 16, whereby boron and carbon were removed from the melt. The residue was subjected to deoxidization, directional solidification and removal by cutting, whereby a product of polycrystalline silicon was obtained. The product was sliced in a similar manner to Example 1, whereby silicon wafers for solar cells were manufactured.

The size, number and performance of the wafer so obtained were much the same with those of the wafer obtained in Example 1.

In conclusion, the advantages of the manufacturing process and apparatus of polycrystalline silicon and manufacturing process of polycrystalline silicon wafers for solar cells according to the present invention will be summarized below compared with the conventional ones.

The processes for manufacturing polycrystalline silicon and polycrystalline silicon wafers for solar cells according to the present invention are free from the source-wise problem (in other words, shortage in raw materials does not occur), do not by-produce pollutants and are essentially suited to the scale up of the equipment and mass production because of a metallurgical technique employed. It is therefore possible to supply wafers stably even if the demand for solar cells will increase by several hundred times in future. In addition, during the manufacture of wafers from high-purity silicon in the mass form, about 20 wt.% of losses and inferior products appear as a result of pulverization or the like. Continuous and consistent manufacture from silicon to wafers according to the present invention, on the other hand, reduces losses, whereby electricity and energy can be used effectively. The price of the silicon wafer available in the enforcement of the present invention can be reduced to half of that of the conventional product, which makes it possible to allow the solar cell to function economically as an electricity generating apparatus.

## Claims

1. A process for manufacturing polycrystalline silicon from metallic silicon, which comprises the following steps:
a. melting metallic-grade silicon under vacuum to remove the phosphorus contained therein by evaporation, and then carrying out directional solidification of the residue for the removal of the impurity elements from the molten silicon, thereby obtaining a first ingot;
b. removing the impurity concentrated portion of the first ingot by cutting;
c. re-melting the remaining portion, removing boron and carbon from the melt by oxidizing under an oxidizing atmosphere, and in succession, blowing an argon gas or a mixed gas of argon and hydrogen into the melt for deoxidization.
d. casting the deoxidized melt in a mold, followed by directional solidification to obtain a second ingot; and
e. removing the impurity concentrated portion of the second ingot by cutting.

2. A process according to claim 1, wherein said metallic-grade silicon is obtained by reductive smelting of silicon.

3. A process according to claim 1 or 2, wherein the above-described oxidizing atmosphere is formed from an H₂ O, CO₂ or O₂ gas in an amount small enough so that the interface between the melt and the gas will not be covered with silicon oxide.

4. A process according to claim 3, wherein silicon oxide formed on the surface of the melt is removed by locally heating by plasma arc.

5. A process according to any one of claims 1 to 4, wherein an H₂ O, CO₂ or O₂ gas is blown into the melt instead of placing the melt under said oxidizing atmosphere.

6. A process according to any one of claims 1 to 5, wherein SiO₂ or Si₃ N₄ is used as a mold releasing agent.

7. A process according to any one of claims 1 to 6, wherein a solidification interface moving rate is set at 5 mm/min or less for the removal of impurities, and a solidification interface moving rate for directional solidification is set at 2 mm/min or less.

8. A process according to any one of claims 1 to 7, wherein said ingot is cut at a height at least 70% above the bottom of the ingot.

9. A process according to any one of claims 1 to 8, wherein the phosphorus concentration of the melt is set at 0.3 ppm or less.

10. A process according to any one of claims 1 to 9, wherein the boron concentration of the melt is set at 0.6 ppm or less.

11. A process according to any one of claims 1 to 10, wherein the carbon concentration of the melt is set at 10 ppm or less.

12. An apparatus for manufacturing polycrystalline silicon, which comprises heating means for melting or heating metallic-grade silicon, a retaining container for retaining the melt, a first directional solidification mold into which the melt is cast from the retaining container, a vacuum chamber for removing phosphorus by evaporation, said chamber surrounding the retaining container and the first mold re-melting means for re-melting or heating a portion of the ingot from the first mold, a smelting container for retaining the re-melt, a nozzle for blowing or spraying an oxidizing gas, hydrogen gas or a mixed gas of hydrogen and argon to the re-melt in the smelting container and a second directional solidification mold for forming the deoxidized re-melt into a cast ingot.

13. An apparatus according to claim 12, wherein the pressure in the vacuum chamber is set at 1,33 Pa or lower.

14. An apparatus according to claim 12 or 13, wherein the retaining container is a water-cooling jacket made of a copper or graphite crucible; and the smelting container is a crucible made of SiO₂ or SiO₂ lined crucible.

15. An apparatus according to any one of claims 12 to 14 wherein said heating means is an electron gun.

16. An apparatus according to any one of claims 12 to 15 wherein said re-melting means is a plasma torch or a DC arc source.

17. An apparatus according to any one of claims 12 to 16 wherein said first and second directional solidification molds have side walls formed of a heat insulating material and have a bottom formed of a water-cooled jacket; a heating source for heating the melt is disposed above the molds.

18. An apparatus according to any one of claims 12 to 17 wherein W/H ratio, that is, the ratio of the diameter W to the height H of said molds is set at grater than 0.5.

19. A process for the production of a silicon wafer for solar cell, which comprises slicing an ingot of polycrystalline silicon obtained in any one of the processes according to claims 1 to 11.

20. A process according to claim 19, the above-described thin plate has a thickness of 100 to 450 µm.

## Patentansprüche

1. Verfahren zum Herstellen von polykristallinem Silizium aus metallischem Silizium, das die folgenden Schritte umfasst:
a. Schmelzen von metallischem Silizium im Vakuum, um den darin enthaltenen Phosphor durch Verdampfen zu entfernen, und anschließendes Ausführen gerichteter Erstarrung des Rückstandes, um die Verunreinigungselemente aus dem geschmolzenen Silizium zu entfernen, um einen ersten Block herzustellen;
b. Entfernen des konzentriert verunreinigten Teils des ersten Blockes durch Abschneiden;
c. erneutes Schmelzen des verbliebenen Teils, wobei Bor und Kohlenstoff durch Oxidieren in einer oxidierenden Atmosphäre aus der Schmelze entfernt werden, und anschließendes Blasen eines Argon-Gases oder eines Gasgemischs aus Argon und Wasserstoff in die Schmelze, um Desoxidation auszuführen;
d. Gießen der desoxidierten Schmelze in eine Form und anschließend gerichtete Erstarrung, um einen zweiten Block herzustellen; und
e. Entfernen des konzentriert verunreinigten Teils des zweiten Blocks durch Abschneiden.

2. Verfahren nach Anspruch 1, wobei das metallische Silizium durch reduzierendes Schmelzen von Silizium hergestellt wird.

3. Verfahren nach Anspruch 1 oder 2, wobei die oben beschriebene oxidierende Atmosphäre aus H₂O-, CO₂- oder O₂-Gas in einer Menge ausgebildet wird, die so gering ist, dass die Grenzfläche zwischen der Schmelze und dem Gas nicht mit Siliziumoxid überzogen wird.

4. Verfahren nach Anspruch 3, wobei Siliziumoxid auf der Oberfläche der Schmelze durch örtlich begrenztes Erhitzen mit Plasmalichtbogen ausgebildet wird.

5. Verfahren nach einem der Ansprüche 1 bis 4, wobei ein H₂O-, CO₂- oder O₂-Gas in die Schmelze geblasen wird, statt die Schmelze der oxidierenden Atmosphäre auszusetzen.

6. Verfahren nach einem der Ansprüche 1 bis 5, wobei SiO₂ oder Si₃N₄ als ein Formtrennmittel eingesetzt wird.

7. Verfahren nach einem der Ansprüche 1 bis 6, wobei eine Erstarrungsgrenzflächen-Bewegungsgeschwindigkeit auf 5 mm/min oder weniger eingestellt wird, um Verunreinigungen zu entfernen, und eine Erstarrungsgrenzflächen-Bewegungsgeschwindigkeit für gerichtete Erstarrung auf 2 mm/min oder weniger eingestellt wird.

8. Verfahren nach einem der Ansprüche 1 bis 7, wobei der Block in einer Höhe von wenigstens 70 % über dem unteren Ende des Blocks geschnitten wird.

9. Verfahren nach einem der Ansprüche 1 bis 8, wobei die Phosphor-Konzentration der Schmelze auf 0,3 ppm oder weniger eingestellt wird.

10. Verfahren nach einem der Ansprüche 1 bis 9, wobei die Bor-Konzentration der Schmelze auf 0,6 ppm oder weniger eingestellt wird.

11. Verfahren nach einem der Ansprüche 1 bis 10, wobei die Kohlenstoff-Konzentration der Schmelze auf 10 ppm oder weniger eingestellt wird.

12. Vorrichtung zum Herstellen von polykristallinem Silizium, die eine Heizeinrichtung zum Schmelzen oder Erhitzen von metallischem Silizium, einen Aufnahmebehälter zum Aufnehmen der Schmelze, eine erste Form für gerichtete Erstarrung, in die die Schmelze aus dem Aufnahmebehälter gegossen wird, eine Vakuumkammer zum Entfernen von Phosphor durch Verdampfen, wobei die Kammer den Aufnahmebehälter und die erste Form umgibt, eine Einrichtung zum Umschmelzen, mit der ein Teil des Blockes aus der ersten Form umgeschmolzen oder erhitzt wird, einen Schmelzbehälter, der die Umschmelze aufnimmt, eine Düse, die ein oxidierendes Gas, Wasserstoff-Gas oder ein Gasgemisch aus Wasserstoff und Argon in die Umschmelze in dem Schmelzbehälter bläst, und eine zweite Form für gerichtete Erstarrung zum Formen der desoxidierten Umschmelze zu einem Gussblock umfasst.

13. Vorrichtung nach Anspruch 12, wobei der Druck in der Vakuumkammer auf 1,33 Pa oder niedriger eingestellt wird.

14. Vorrichtung nach Anspruch 12 oder 13, wobei der Aufnahmebehälter eine Wasser-Kühlummantelung aus Kupfer oder ein Grafittiegel ist und der Schmelzbehälter ein Tiegel, der aus SiO₂ besteht, oder ein mit SiO₂ ausgekleideter Tiegel ist.

15. Vorrichtung nach einem der Ansprüche 12 bis 14, wobei die Heizeinrichtung eine Elektronenstrahlkanone ist.

16. Vorrichtung nach einem der Ansprüche 12 bis 15, wobei die Umschmelzeinrichtung ein Plasmabrenner oder eine Gleichspannungs-Lichtbogen-Quelle ist.

17. Vorrichtung nach einem der Ansprüche 12 bis 16, wobei die erste und die zweite Form für gerichtete Erstarrung Seitenwände aufweisen, die aus einem wärmeisolierenden Material bestehen, und einen Boden aufweisen, der aus einer wassergekühlten Ummantelung entsteht, und wobei eine Heizquelle zum Erhitzen der Schmelze über den Formen angeordnet ist.

18. Vorrichtung nach einem der Ansprüche 12 bis 17, wobei das Verhältnis W/H, d.h. das Verhältnis des Durchmessers W zur Höhe H der Formen, auf mehr als 0,5 eingestellt ist.

19. Verfahren zum Herstellen eines Silizium-Wafers für Solarzellen, das das Schneiden eines Blocks aus polykristallinem Silizium, der mit einem der Verfahren nach den Ansprüchen 1 bis 11 hergestellt wurde, in Scheiben umfasst.

20. Vorrichtung nach Anspruch 19, wobei die oben beschriebene dünne Platte eine Dicke von 100 bis 450 µm hat.

## Revendications

1. Procédé de fabrication de silicium polycristallin à partir de silicium métallique, qui comprend les étapes suivantes :
a. fusion de silicium de qualité métallique sous vide pour enlever le phosphore contenu dans celui-ci par évaporation, puis réalisation d'une solidification directionnelle du résidu pour l'enlèvement des éléments d'impureté du silicium fondu, en obtenant, de ce fait, un premier lingot ;
b. enlèvement de la partie concentrée en impuretés du premier lingot par coupe ;
c. refusion de la partie restante, enlèvement du bore et du carbone du métal fondu par oxydation sous une atmosphère oxydante, et, dans l'ordre, soufflage d'un gaz argon ou d'un gaz mélangé d'argon et d'hydrogène dans le métal fondu pour désoxydation.
d. coulée du métal fondu désoxydé dans un moule, suivie d'une solidification directionnelle pour obtenir un second lingot ; et
e. enlèvement de la partie concentrée en impuretés du second lingot par coupe.

2. Procédé selon la revendication 1, dans lequel ledit silicium de qualité métallique est obtenu par fusion réductrice de silicium.

3. Procédé selon la revendication 1 ou 2, dans lequel l'atmosphère oxydante décrite précédemment est formée à partir d'un gaz O₂ ou H₂O ou CO₂ dans une quantité suffisamment faible pour que l'interface entre le métal fondu et le gaz ne soit pas recouverte d'oxyde de silicium.

4. Procédé selon la revendication 3, dans lequel l'oxyde de silicium formé à la surface du métal fondu est enlevé par chauffage local à l'arc plasma.

5. Procédé selon l'une quelconque des revendications 1 à 4, dans lequel du gaz O₂ ou H₂O ou CO₂ est soufflé dans le métal fondu au lieu de placer le métal fondu sous ladite atmosphère oxydante.

6. Procédé selon l'une quelconque des revendications 1 à 5, dans lequel du SiO₂ ou Si₃N₄ est utilisé comme agent de démoulage.

7. Procédé selon l'une quelconque des revendications 1 à 6, dans lequel une vitesse de déplacement d'interface de solidification est réglée à 5 mm/min ou moins pour l'enlèvement d'impuretés, et une vitesse de déplacement d'interface de solidification pour la solidification directionnelle est réglée à 2 mm/min ou moins.

8. Procédé selon l'une quelconque des revendications 1 à 7, dans lequel ledit lingot est coupé à une hauteur d'au moins 70 % au-dessus de la partie inférieure du lingot.

9. Procédé selon l'une quelconque des revendications 1 à 8, dans lequel la concentration de phosphore du métal fondu est réglée à 0,3 ppm ou moins.

10. Procédé selon l'une quelconque des revendications 1 à 9, dans lequel la concentration de bore du métal fondu est réglée à 0,6 ppm ou moins.

11. Procédé selon l'une quelconque des revendications 1 à 10, dans lequel la concentration de carbone du métal fondu est réglée à 10 ppm ou moins.

12. Appareil pour fabriquer du silicium polycristallin, qui comprend un moyen de chauffage pour fondre ou chauffer du silicium de qualité métallique, un conteneur de conservation pour conserver le métal fondu, un premier moule de solidification directionnelle dans lequel le métal fondu est coulé à partir du conteneur de conservation, une chambre à vide pour enlever le phosphore par évaporation, ladite chambre entourant le conteneur de conservation et le moyen de refusion du premier moule pour refondre ou chauffer une partie du lingot à partir du premier moule, un conteneur de fusion réduction pour conserver le métal refondu, une buse pour souffler ou pulvériser un gaz oxydant, du gaz hydrogène ou un gaz mélangé d'hydrogène et d'argon sur le métal refondu dans le conteneur de fusion réduction et un second moule de solidification directionnelle pour former le métal refondu désoxydé en un lingot coulé.

13. Appareil selon la revendication 12, dans lequel la pression dans la chambre à vide est réglée à 1,33 Pa ou moins.

14. Appareil selon la revendication 12 ou 13, dans lequel le conteneur de conservation est une chemise de refroidissement par eau constitué d'un creuset en graphite ou en cuivre ; et dans lequel le conteneur de fusion réduction est un creuset constitué de SiO₂ ou un creuset revêtu de SiO₂.

15. Appareil selon l'une quelconque des revendications 12 à 14, dans lequel ledit moyen de chauffage est un canon à électrons.

16. Appareil selon l'une quelconque des revendications 12 à 15, dans lequel ledit moyen de refusion est une torche plasma ou une source à arc CC.

17. Appareil selon l'une quelconque des revendications 12 à 16, dans lequel lesdits premier et second moules de solidification directionnelle ont des parois latérales formées d'un matériau calorifuge et ont une partie inférieure formée d'une chemise de refroidissement par eau ; une source de chauffage pour chauffer le métal fondu est disposée au-dessus des moules.

18. Appareil selon l'une quelconque des revendications 12 à 17, dans lequel le rapport W/H, c'est-à-dire, le rapport du diamètre W à la hauteur H desdits moules est réglé sur une valeur supérieure à 0,5.

19. Procédé pour la production d'une plaquette en silicium pour cellule solaire, qui comprend le sciage en tranches d'un lingot de silicium polycristallin obtenu dans l'un quelconque des procédés selon les revendications 1 à 11.

20. Procédé selon la revendication 19, dans lequel la plaque fine décrite précédemment a une épaisseur de 100 à 450 µm.
